(19) Europäisches Patentamt
European Patent Office
Office européen des brevets

(11) **EP 4 310 227 A1**

(12) **EUROPEAN PATENT APPLICATION**

(43) Date of publication:
**24.01.2024 Bulletin 2024/04**

(21) Application number: **22186468.9**

(22) Date of filing: **22.07.2022**

(51) International Patent Classification (IPC):
**C30B 13/24** (2006.01)   **C30B 29/22** (2006.01)

(52) Cooperative Patent Classification (CPC):
**C30B 29/22; C30B 13/24**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.07.2022 PT 2022118114**

(71) Applicant: **Universidade de Aveiro
3810-193 Aveiro (PT)**

(72) Inventors:
- **MENDES DA COSTA, Florinda
3810-193 Aveiro (PT)**
- **FREITAS FERREIRA, Nuno Miguel
3810-193 Aveiro (PT)**
- **BREDA LOPES, Diogo João
3810-193 Aveiro (PT)**
- **KAVALEUSKI, Andrei
3810-193 Aveiro (PT)**

(74) Representative: **Monteiro Alves, Inês
Alameda Dos Oceanos, № 41K-21
Parque das Nações
1990-207 Lisboa (PT)**

(54) **METHODS AND SYSTEM FOR PRODUCING TEXTURED TRANSITION METAL-DOPED TITANIUM OXIDE ELECTROCERAMICS BY LASER FLOATING ZONE UNDER REDUCING ATMOSPHERE AND PRODUCT THEREOF**

(57)   The present invention concerns methods and system for growing $Ti_{1-x}M_xO_{2-y}$ fibres, wherein M is a transition metal from group 5 of the Periodic Table, with 0.1<x<0.4 and 0<y<0.2. The growth being performed under a reducing atmosphere, using the laser floating zone technique (LFZ) to obtain textured, oriented and crystalline $Ti_{1-x}M_xO_{2-y}$ fibres having improved thermoelectric properties.

The LFZ technique allows the application of various reducing atmospheres in a range of relative pressures such as from 0.1 to $1.5 \times 10^5$ Pa. The system includes a growth chamber, an atmosphere control subsystem, a continuous laser beam, and an optical apparatus to focus the laser beam.

The present invention is useful for producing said $Ti_{1-x}M_xO_{2-y}$-based fibres with high thermoelectric properties, due to the combination of a reducing atmosphere with the growth conditions, which is of interest mainly in the field of thermoelectric applications.

Fig.2

EP 4 310 227 A1

**Description**

**TECHNICAL FIELD OF THE INVENTION**

The present invention is related to the field of material production processes, more particularly, the invention is related to the field of material production processes mainly directed to thermoelectric applications and the semiconductor industry.

The present invention concerns methods for growing electroceramic material fibres comprising $Ti_{1-x}M_xO_{2-y}$ under a reducing atmosphere, wherein M is a transition metal chosen from group 5 of the Periodic Table, x being in the range from 0.1 to 0.4, preferably from 0.1 to 0.2 and y in the range from 0 to 0.2, using the laser floating zone technique (LFZ), to obtain textured, oriented, crystalline $Ti_{1-x}M_xO_{2-y}$ fibres, with various phase composition and microstructure, improving their thermoelectric properties. The present invention also relates to a system configured to implement the methods according to the present invention, and to the electroceramic material fibre thus obtained.

**BACKGROUND OF THE INVENTION**

The original process of crystals growth discovered in 1904 by A. Verneuil, using a flame as a heat source, reaching melting temperatures of around 2,000 °C, has undergone significant improvements. This discovery was the basis for the development of the well-known Czochralski method, which is currently the most widely used crystal growth method.

Subsequently, the process has evolved into a crucibleless method where multiple heating sources can be used, such as induction coils, ovens, lamps and, more recently, lasers. The introduction of laser technology has enabled the production of materials in the form of fibre and allows the melting of materials with a high melting point which, using conventional methods, would be practically impossible. Since laser technology does not require the use of crucibles, it is possible to obtain fibres (amorphous, monophasic or polyphasic) with a high degree of purity, avoiding contamination and mechanical stresses that may arise during the cooling process (solidification) due to the crucible.

As will be appreciated by a person skilled in the art, this technique, denominated as Laser Floating Zone (LFZ), is a fast and very useful process to produce fibres through a directional solidification from a melting state.

The LFZ technique requires equipment that controls and monitors the growth process, to provide a uniform radial fusion and the rotation and translation movements of the feed and seed precursors.

As a person skilled in the art will understand, the growth process by LFZ is based on the law of mass conservation, in such a way that it is necessary to maintain a constant diameter in the melting zone, which implies that the speed of feeding and growth rates should be constant during the process. The ratio between the speed of linear displacement of the two precursors (feed and seed) will determine the diameter of the fibre.

Also, the growth rate and the thermal conductivity of the material determine the temperature gradient at the crystallization interface.

In some cases, a rapid growth can be advantageous to minimize the vaporization process, by shortening the time under fusion. However, in most cases, slow growth rates lead to materials with better crystallinity.

In general, the main parameters that should be controlled during fibres growth are the characteristics of the precursors (seed and feed rod); the growth rate; the atmosphere and pressure inside the growth chamber; the temperature gradient; the temperature of the molten zone and the speed of rotation. As a person skilled in the art will appreciate, the effect of these parameters is even more pronounced on the growth of materials that have high density, low surface tension or a complex phase diagram. This method, i.e., the LFZ technique, has already been used to study phase transformations, diffusion phenomena and crystallization paths of different systems.

The materials obtained by LFZ can exhibit a preferential grain alignment due to the strong thermal gradient at the solidification interface. Another advantage of the LFZ method is the high temperature that can be achieved due to the laser beam focusing apparatus. This technique, also, allows the formation of high-temperature metastable phases and the crystallization of incongruent phases due to the high thermal gradients generated in the crystallization interface, which can reach values from 1,000 to 10,000 °C / cm. This is a further advantage, since the phases able to be obtained by the LFZ technique are difficult or impossible to obtain by other methods.

Another particularity of this method is the conditions away from equilibrium during the melting and cooling processes. The equilibrium in question is thermodynamic equilibrium. The melting process followed by rapid cooling does not let the substances involved in the process reach thermodynamic equilibrium in terms of composition. This results in unique microstructural changes, such as texturing, and eventually better thermoelectric performance. A further advantage for thermoelectric performance is the fact that rapid cooling allows freezing the structure of the material at high temperature, which favors better electrical properties, while in the case of slow cooling, the structure of the resulting material will be closer to equilibrium, i.e. the structure that corresponds to a lower or even room temperature.

One type of materials that have a great potential to benefit from the above-mentioned LFZ is the thermoelectric materials type.

As it will be appreciated by a person skilled in the art, thermoelectric materials make use of the Seebeck effect to produce an electrical voltage from a temperature difference. One way of evaluating the thermoelectric performance of the materials is using its Power Factor (PF), wherein the PF can be defined by the following formula:

$$PF = \sigma S^2 \; (Wm^{-1}k^{-2})$$

wherein $\sigma$ is the electrical conductivity and S the Seebeck coefficient.

A higher power factor will be imparted to the material, assuming a fixed geometry and an endless source of heating and cooling, being able to generate more energy, either move more heat or extract more energy from the temperature difference.

Mohammad A. Alim et al. [1], in 2016, reported the electrical properties of polycrystalline Ta-doped $TiO_2$ obtained in a solid state reaction in an atmosphere with a controlled oxygen activity, and the effect of this oxygen activity on the electrical conductivity and thermoelectric power. They reported that the tantalum incorporation increases the electrical conductivity, being more substantial in reducing conditions.

On the other hand, F. P. Carreira et al. [2], in 2020, produced praseodymium substituted $CaMnO_3$ fibres, in an argon atmosphere for high-temperature thermoelectric energy conversion, reporting a lower electrical conductivity and a higher amount of phase impurities in the fibres grown under argon atmosphere. In this prior art, the CaMnO3 based materials are processed in an argon atmosphere, in which the conductivity of the grown fibres actually decreases.

## SUMMARY OF THE INVENTION

The present invention concerns methods for growing, under a controlled reducing atmosphere, electroceramic material fibres comprising $Ti_{1-x}M_xO_{2-y}$ wherein M is a transition metal chosen from group 5 of the Periodic Table, x is in the range from 0.1 to 0.4, preferably from 0.1 to 0.2 and y is in the range from 0 to 0.2, using the laser floating zone technique (LFZ), to obtain said textured, oriented and crystalline $Ti_{1-x}M_xO_{2-y}$ fibres, allowing to tune phase composition and microstructures, improving their thermoelectric properties. The invention also relates to a system configured to implement any one of the methods according to the present invention, and to an electroceramic material fibre obtained thereby.

The methods according to the present invention are carried out under a controlled reducing atmosphere. Such reducing atmosphere can be a mixture of $H_2/N_2$, or vacuum, in a wide range of pressures and oxygen partial pressures, such as a relative pressure in the range from 0.1 to $1.5 \times 10^5$ Pa.

The system according to the present invention, configured to carry out the methods of the invention, includes a growth chamber inside which a continuous $CO_2$ laser beam focused on the precursor rods creating a melting zone (3) which will enable fibres growth. The laser beam is focused through an optical apparatus (4). The system also comprises a vacuum subsystem configured to remove air from the chamber and a subsystem configured to provide the desired gaseous atmosphere into the chamber. The combination of a controlled atmosphere with the LFZ technique can be achieved by using a gas-tight chamber, with the growing apparatus placed inside it.

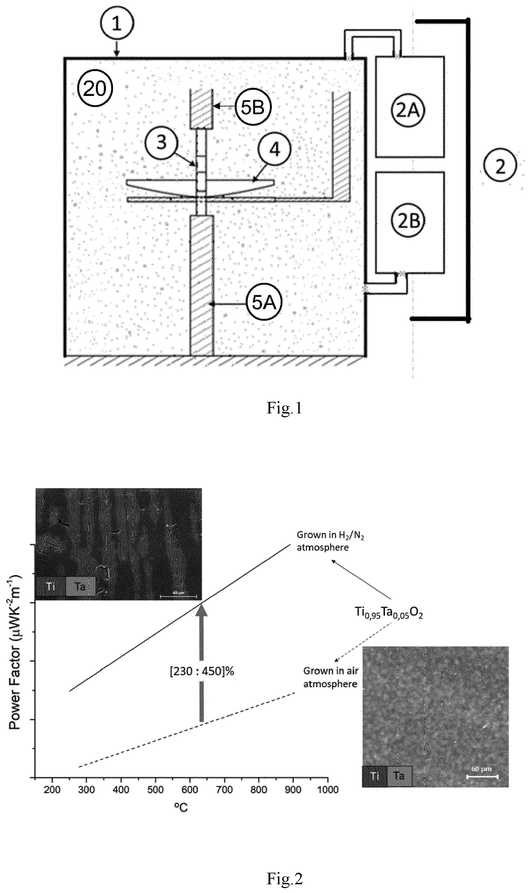

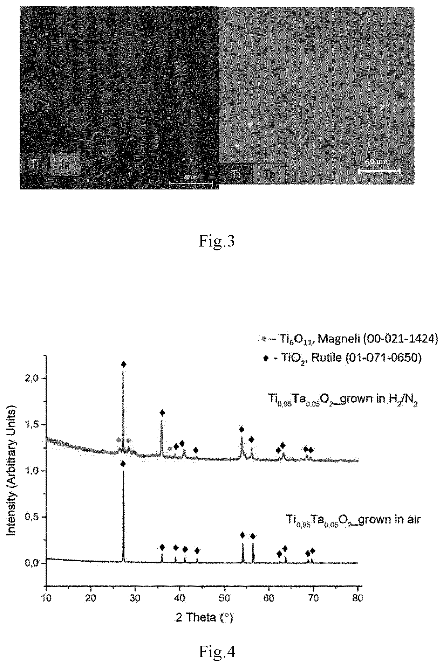

The obtained $Ti_{1-x}M_xO_{2-y}$ fibres according to the present invention wherein M is as defined above, x is in the range from 0.1 to 0.4, preferably from 0.1 to 0.2 and y in the range from 0 to 0.2, show an increase in the electrical conductivity and thermoelectric properties (see Figs. 2 and 3), as compared to the conventional growth methods. These improvements are related to the use of a reducing atmosphere during their growth by means of the LFZ technique.

The type of reducing atmosphere used during growth can be varied, e.g., from a vacuum atmosphere of air to a reducing mixture like $H_2/N_2$. The pressure in the chamber can thus be controlled.

## TECHNICAL PROBLEM

None of the prior art techniques mentioned above was so far able to tune the phase composition and the microstructure of materials processed by means of either a laser-based or a solid state-based technique such that said materials could reach higher thermoelectric properties. Therefore, with a view to obtain materials offering better suited characteristics for thermoelectric applications and for the semiconductor industry, such as for waste heat harvesting, there is still a need of methods and systems able to obtain such materials as well as said materials.

## SOLUTION TO TECHNICAL PROBLEM

The use of a controlled reducing atmosphere at high temperatures allows modifications in the way that the material is processed. The use of various reducing atmospheres will open a whole new range of possibilities for tuning the phase composition and microstructure of the materials processed by the LFZ, leading to a product providing significantly higher thermoelectric properties with the additional advantage of not requiring further machining for their main applications.

## ADVANTAGEOUS EFFECTS OF THE INVENTION

The present invention relates to methods and system for the production of $Ti_{1-x}M_xO_{2-y}$-based fibres, wherein M is as defined above, x is in the range from 0.1 to 0.4, preferably from 0.1 to 0.2 and y in the range from 0 to 0.2, with high electrical conductivity, due to improvements provided by the application of a reducing atmosphere during growth, such as a mixture of $H_2/N_2$, or vacuum, allowing to control the oxygen partial pressure, and which is of interest in several fields, such as thermoelectrics and semiconductors.

Therefore, the present invention is particularly useful in the production of said textured, oriented $Ti_{1-x}M_xO_{2-y}$-based crystalline fibres, obtained by solidification of melted material at high temperatures. Thus, the methods according to the present invention allow a significant improvement in the thermoelectrical properties of these fibres, also due to the type of microstructure and phase distribution/formation obtained in the fibres.

As it will be appreciated by a person skilled in the art, in the majority of the cases, a better crystalinity results in higher thermoelectric performance. Therefore, the methods according to the present invention, by using a relatively slow growth speed, i.e., in the range of 0.1-1000 mm/h, preferably in the range of 0.1-100 mm/h, more preferably in the range of 10-100 mm/h, lead to fibres having a better crystallinity.

## BRIEF DESCRIPTION OF THE FIGURES

Preferred embodiments of the present invention will be described with reference to the accompanying figures, which are to be construed as non-limiting the invention scope, which scope is defined by the appended claims, and wherein:

Figure 1 shows a schematic representation of an embodiment of the system according to the present invention, by means of which the methods according to the invention can be carried out;

Figure 2 shows a graph plotting the magnitude of power factors obtained by fibres grown in air (prior art) and by a method according to the present invention;

Figure 3 shows the SEM/EDS (Scanning Electron Microscopy / Energy Dispersive Spectroscopy) obtained for the two different fibre structure power factors shown in Figure 2; and

Figure 4 shows an XRD diffractogram showing the effect of growing fibres under a reduction atmosphere and in air conditions (prior art).

## DEFINITIONS

Throughout this application, the terms "around" and "approximately" mean that the value to which they refer could also be within a range of plus and minus 10 % of the mentioned value.

## GENERAL DESCRIPTION OF THE INVENTION

The present invention is related to methods using the Laser Floating Zone (LFZ) technique under a controlled reducing atmosphere to produce $Ti_{1-x}M_xO_{2-y}$-based fibres, wherein M is a transition metal chosen from group 5 of the Periodic Table, x is from 0.1 to 0.4, preferably from 0.1 to 0.2 and y is from 0 to 0.2. The use of a reducing atmosphere allows a controlled reduction of the fibre components produced. The oxidation states of the cations of said $Ti_{1-x}M_xO_{2-y}$ based electroceramics affect the generation and mobility of the charge carriers, opening a possibility to improve the thermoelectric properties in such materials.

For this purpose, the present invention describes processing methods to promote the growth of said $Ti_{1-x}M_xO_{2-y}$-based fibres, implemented by a system comprising a gas-tight chamber inside which the growth of the fibre will occur. The system further comprises a laser and mirror apparatus for focusing the laser beam on a precursor rod, and an atmosphere arrangement including a vacuum subsystem and a pressurized gas source.

The methods herein provided include the replacement of the air inside the chamber where the growth occurs, by an atmosphere with different properties such as reducing.

The laser source used in the present invention has the function of being the heat source that provides enough energy to reach the melting temperature of the precursor materials without the need for crucibles. Suitable laser sources within the scope of the present invention are, for example, gaseous lasers based on $CO_2$.

The system according to the present invention comprises a laser source as described above, and an optical apparatus. Said optical apparatus is of the parabolic type, thereby allowing to change the shape of the laser beam from a spot into a circular crown shape, and finally to focus the beam on the material to be melted.

The system according to the invention further comprises a growth chamber, in which all the optical components for changing the shape of the beam are located. The system further comprises two spindles (one for the feed rod and another one for the seed rod) which are used to hold, rotate, and vertically translate the seed and feed rods.

The present invention allows the growth of $Ti_{1-x}M_xO_{2-y}$-based fibres at pressures near the atmospheric pressure or under vacuum conditions as per defined below, which fibres are doped with transition metals, represented by letter M in the formula above. Additionally, this method has the particularity of allowing it to be applied under reducing atmospheres.

A fibre growth process is significantly influenced by different parameters including growth rates, laser power, and rotation speeds. One of the most important parameters is the growth rates of the seed and feed rods. High growth rates will favor the formation of amorphous material phases while slower rates promote almost single crystal growth. Slower rates will improve alignment of the phases, in opposite to faster rates. Therefore growth rate should be selected taking into account the specificity of the material. In this application, growth rates vary between 0.1 and 1000 mm/h, preferably between 0.1 and 100 mm/h, more preferably between 10 and 100 mm/h. $Ti_{1-x}Ta_xO_{2-y}$ rods were used as both feed and seed precursors.

Thus, the present invention describes methods and system to produce said textured, oriented and crystalline $Ti_{1-x}M_xO_{2-y}$-based fibres, which comprise the application of a reducing atmosphere to the laser floating zone (LFZ) technique.

The application of a reducing atmosphere to the LFZ technique can be achieved by using a gas-tight reactor (growth chamber), with the LFZ apparatus inside it. The method to change the atmosphere uses a vacuum subsystem (2A) to remove the air inside the chamber. In a preferred embodiment of the present invention, this is followed by the controlled inlet of the desired gas until a desired pressure around atmospheric pressure is achieved inside the chamber. Another option to change the atmosphere inside the growth chamber involves just replacing the air inside the chamber, although it is a slower process. The establishment of the desired atmosphere inside the chamber can be performed manually, however, it is possible to perform it using a computer and a valve and pressure gauge subsystem.

The $Ti_{1-x}Ta_xO_{2-y}$ based fibres thus obtained show a great improvement in their thermoelectric properties (see Figs. 2 and 3), which is a consequence of the specific atmosphere applied during processing.

Thus, the present invention is particularly useful in the production of said textured, oriented, crystalline $Ti_{1-x}M_xO_{2-y}$-based fibres obtained by solidification of molten materials at high temperatures. The methods according to the present invention allow the formation of favourable structure and microstructure, improving the electrical properties of the as-grown fibres. In this way, it contributes to improving the physical properties, namely the charge carrier characteristics.

## DESCRIPTION OF EMBODIMENTS OF THE INVENTION

In a first aspect, the present invention refers to a method of producing, by means of the Laser Floating Zone (LFZ) technique, an electroceramic fibre of the following formula (I):

$$Ti_{1-x}M_xO_{2-y} \qquad (I)$$

wherein, in formula (I):

M is a transition metal chosen from group 5 of the Periodic Table;
x is in the range from 0.1 to 0.4, preferably from 0.1 to 0.2;
y is in the range from 0 to 0.2;

wherein said method comprises the steps:
feeding two precursor rods, one feed precursor rod and one seed precursor rod, wherein said rods are made of a mixture comprising materials of formulas (II) and (III):

$$TiO_z \qquad (II)$$

wherein, in formula (II):
z is in the range from 1.8 to 2.25;

$$M_kO_w \qquad (III)$$

wherein, in formula (III):

M is a transition metal chosen from group 5 of the Periodic Table;
k is in the range from 1.9 to 2.1;
w is in the range from 4.9 to 5.1;
b) placement and vertical end-to-end alignment of said feed precursor rod and said seed precursor rod within a gas-tight growth chamber wherein the vertical end-to-end alignment of the feed precursor rod and the seed precursor rod is such that their ends are facing each other;
c) start the rotation of the feed precursor rod and the seed precursor rod in opposite directions relatively to each other;
d) focus a laser beam on the feed precursor rod, at the end of said feed precursor rod, said end being the one facing the end of the seed precursor rod;
e) increase the laser power until said end of the feed precursor rod melts;
f) join the ends of the feed precursor rod and the seed precursor rod until a uniform molten zone is achieved;
g) set a feed speed and a growth speed, wherein the growth speed is the speed of the seed rod and is in the range of 0.1-1000 mm/h, preferably in the range of 0.1-100 mm/h, more preferably in the range of 10-100 mm/h; wherein the feed speed is adjusted such that a diameter of the melting zone is kept constant and is in the range of 0.1-1000 mm/h, preferably in the range of 0.1-100 mm/h, more preferably in the range of 10-100 mm/h;
h) start fibre growth by moving the rods vertically at the growth speed respectively to the laser beam focus;

said method comprising the additional following step:

b') pump the air out of the growth chamber by means of a vacuum subsystem (2A) until a pressure lower than the atmospheric pressure is achieved, wherein the pressure achieved is preferably from 1 to $10^3$ Pa;
wherein step b') occurs after step b) and before step c).

In a second aspect, the present invention refers to another method, which another method is a method of producing by means of the Laser Floating Zone (LFZ) technique an electroceramic fibre of the formula (I):

$$Ti_{1-x}M_xO_{2-y} \qquad (I)$$

wherein, in formula (I):

M is a transition metal chosen from group 5 of the Periodic Table;
x is in the range from 0.1 to 0.4, preferably from 0.1 to 0.2;
y is in the range from 0 to 0.2;

wherein said method comprises the steps:
feeding two precursor rods, one feed precursor rod and one seed precursor rod, wherein said rods are made of a mixture comprising materials of formulas (II) and (III):

$$TiO_z \qquad (II)$$

wherein, in formula (II):
z is in the range from 1.8 to 2.25;

$$M_kO_w \qquad (III)$$

wherein, in formula (III):

M is a transition metal chosen from group 5 of the Periodic Table;
k is in the range from 1.9 to 2.1;
w is in the range from 4.9 to 5.1;
b) placement and vertical end-to-end alignment of said feed precursor rod and said seed precursor rod within a gas-tight growth chamber wherein the vertical end-to-end alignment of the feed precursor rod and the seed precursor rod is such that their ends are facing each other;

c) start the rotation of the feed precursor rod and the seed precursor rod in opposite directions relatively to each other;

d) focus a laser beam on the feed precursor rod, at the end of said precursor rod, said end being the one facing the end of the seed precursor rod;

e) increase the laser power until said end of the feed precursor rod melts;

f) join the ends of the feed precursor rod and the seed precursor rod until a uniform molten zone is achieved;

g) set a feed speed and a growth speed, wherein the growth speed is the speed of the seed rod and is in the range of 0.1-1000 mm/h, preferably in the range of 0.1-100 mm/h, more preferably in the range of 10-100 mm/h; wherein the feed speed is adjusted such that a diameter of the melting zone is kept constant and is in the range of 0.1-1000 mm/h, preferably in the range of 0.1-100 mm/h, more preferably in the range of 10-100 mm/h;

h) start fibre growth by moving the rods vertically at the growth speed respectively to the laser beam focus;

said method comprising the additional following step:

b") fill the growth chamber with a gas provided by means of a pressurization subsystem comprising a pressurized gas source (2B) until a relative pressure in the range from 0.1 to $1.5 \times 10^5$ Pa is achieved; and wherein step b") occurs after step b) and before step c).

In a preferred embodiment of the second aspect, the present invention refers to a method comprising the following additional step:

b') pump the air out of the growth chamber by means of said vacuum subsystem (2A) until a pressure lower than the atmospheric pressure is achieved, wherein the pressure achieved is preferably from 1 to $10^3$ Pa; wherein step b') occurs after step b); and step b') occurs before step b").

In another embodiment of any of the above-mentioned aspects, the vertical movement of the rods is an upward movement or the vertical movement of the rods is a downward movement, which movement is performed at said growth speed set in step g).

Yet in another embodiment of any of the above-mentioned aspects, said laser beam is emitted from a $CO_2$ laser source, which electromagnetic wave has a wavelength of around 10,600 nm.

Still in another embodiment of the present invention, said feed and seed rods' material is able to absorb radiation of a wavelength of around 10,600 nm.

In an embodiment of the second aspect of the present invention, the pressurized gas from the source of pressurized gas source (2B) comprises a reducing gas, for example, hydrogen, or a reducing mixture of hydrogen and any other suitable gas.

In a third aspect, the present invention refers to an electroceramic fibre comprising an oxide of the formula (I):

$$Ti_{1-x}M_xO_{2-y} \qquad (I)$$

wherein, in formula (I):

M is a transition metal chosen from group 5 of the Periodic Table;
x is in the range from 0.1 to 0.4, preferably from 0.1 to 0.2;
y is in the range from 0 to 0.2;
said electroceramic fibre being an oriented, texturized fibre rod with a crystalline structure.

In preferred embodiments of the third aspect, said electroceramic fibre is obtained by any one of the methods as defined hereinbefore.

Still in other embodiments of the third aspect, said transition metal M is Tantalum (Ta) and/or Niobium (Nb), preferably transition metal M is Ta.

In preferred embodiments of the third aspect, said electroceramic fibre has high thermoelectric properties, such high thermoelectric properties having a power factor from 100 to 1500 $\mu W/m/K^2$.

In a fourth aspect, the present invention refers to a system configured to implement any one of the methods described hereinbefore, said system comprising the following:

- a gas-tight growth chamber (1);
- at least one laser beam source;
- at least one optical apparatus to focus the laser beam (4);
- two spindles, one lower spindle (5A) and one upper spindle (5B), wherein the lower spindle (5A) is orthogonally connected to the internal bottom face of the gas-tight growth chamber (1) and the upper spindle (5B) is orthogonally connected to the internal top face of the gas-tight growth chamber (1), said top face opposite to the bottom face;

said system further comprising

an external atmosphere generator arrangement (2), fluidly connected to the gas-tight growth chamber (1), wherein the external atmosphere generator arrangement (2) comprises:

a vacuum subsystem (2A) connected in fluid communication to said gas-tight growth chamber (1); and
at least one pressurization subsystem comprising a pressurized gas source (2B), which is connected in fluid communication to said gas-tight growth chamber (1);

wherein said vacuum subsystem (2A) and/or said pressurization subsystem comprising a pressurized gas source source (2B) are configured to provide a desired atmosphere inside the growth chamber.

In preferred embodiments of the fourth aspect, said vacuum subsystem (2A) is configured to generate a pressure lower than the atmospheric pressure inside the gas-tight growth chamber (1), for example, a pressure from 1 to $10^3$ Pa.

Yet in preferred embodiments of the fourth aspect, said pressurization subsystem comprises a gas source (2B) containing gas at a pressure higher than the atmospheric pressure, for example, at a relative pressure from 0.1 up to around $1.5 \times 10^5$ Pa.

## DETAILED DESCRIPTION OF THE FIGURES

Figure 1 illustrates an embodiment of the system according to the present invention. Said system comprises a growth chamber (1), which is a gas-tight chamber configured to contain other system components, as well as the atmosphere (20) created and maintained inside it, e.g., $H_2/N_2$ atmosphere with a relative pressure in the range from 0.1 to $1.5 \times 10^5$ Pa.

Connected to the growth chamber (1) is an external atmosphere generator arrangement (2) comprising one or more vacuum pumps (2A) used to remove the air from the growth chamber, and one or more gas bottles (2B) used to fill the growth chamber with the desired atmosphere, wherein both the vacuum pumps (2A) and the gas bottles (2B) are connected to the chamber via fluidly communication pipes provided with valves. Inside said growth chamber (1) the LFZ growth apparatus is placed, i.e., one or more spindles (5A,5B) used for rotation and vertical movement of the seed and feed precursor rods, whereby creating a fibre melting zone (3), which is the zone where both precursor rods abut and melt, one or more reflective mirrors of an optical apparatus (4) configured to focus the laser beam on the top rod, whereby creating the melting zone (3). Inside the growth chamber (1), a controlled atmosphere (20) is created, which atmosphere is intended to be a reducing atmosphere for the purposes of the methods according to the present invention.

Figure 2 shows a graph comparing the Power Factor (PF) obtained by growing $Ti_{0.95}Ta_{0.05}O_2$ fibres, one grown in air (dotted line) representing prior art, and the other one grown in an $H_2/N_2$ atmosphere (continuous line), representing a preferred embodiment of the present invention. A significant increase of PF at 300 - 900 °C is shown. For example, an increase for the samples grown in $H_2/N_2$ atmosphere when compared to the samples grown in air. This increase is due to the effect of the reduction atmosphere creating a reduction of the sample and corresponding changes in morphology and texture. This significant increase is also shown in Table 1 below and further discussed in reference thereto. Figure 2 further shows the microstructure obtained for the same fibres, described in more detail in reference to Figure 3.

Figure 3 shows a SEM/EDS obtained for the two fibres grown in air and in an atmosphere according to the present invention with the different PF shown in Fig. 2. These SEM/EDS images are obtained from the samples grown in air and in $H_2/N_2$ atmospheres which data is shown in Table 1 (present invention and prior art).

Figure 4 shows an X-Ray Diffractogram (XRD) showing the effect of growing fibres under reduction atmosphere and under air conditions. It can be seen in the XRD that different crystalline phases were obtained in the fibres grown in air and in a $H_2/N_2$ atmosphere. The phase composition of the sample grown in $H_2/N_2$ is the most suitable for thermoelectric properties when compared to the phase composition obtained for the sample grown in air. The results shown in Table 1, namely the PF and the Seebeck coefficient, correspond to the samples which XRD is shown in Figure 4. The diffractogram confirms the predominant formation of a desired $TiO_2$-based $Ti_{1-x}Ta_xO_2$ Rutile phase, accompanied by a minor fraction of $Ti_6O_{11}$ Magneli phase. In Figure 4, the references 00-21-1424 and 01-071-0650 correspond to the standard PDF (powder diffraction file) cards of Magneli and Rutile phase, respectively.

As it can be appreciated by a person skilled in the art, Rutile phase is the main desired phase since this phase acts as a main trigger for higher thermoelectric performance of crystalls. As seen in Table 1, the crystalline structure obtained for the samples of fibres grown in air against the one grown in $H_2/N_2$ atmosphere, good thermoelectric properties were achieved, as per confirmed throught the high PF values obtained for them. Higher reduction of this phase and its microstructural evolution achieved by the present invention are responsible for the improved thermoelectric properties.

## EXAMPLES

The methods provided in the present application was used for fibre growth in a hydrogen/nitrogen mixture and in air. In general, hydrogen (pure or in a mixture), nitrogen, and argon may be used in the methods according to the present invention. The limitation is in the availability of the gases and not in the type of gas. Reducing gases include hydrogen, and inert gases such as argon and nitrogen. The presence of oxygen is generally undesirable in the growth atmosphere, if good thermoelectric performance is a primary target. Reducing atmospheres like $H_2/N_2$ result in better thermoelectric performance, as shown by the results provided in this disclosure.

Although titanium-tantalum oxides were already prepared and characterised for various applications, their thermoelectric properties were not systematically studied so far. However, some published results still can be compared to the results achieved by the present invention. Table 1 gives results obtained by the methods according to the present invention which can be compared to methods from the prior art and also methods found in literature [1]. We can observe an increase of the electrical conductivity of the fibres growth according to the present invention, and a decrease of the Seebeck coefficient. This relation of conductivity and Seebeck coefficient is been reported in the literature due to the changes in charge carriers concentration in the samples. Beyond that, the increase of conductivity is more pronounced in the samples obtained according to the present invention leading to an increase of the PF, when compared to the literature [1]. Moreover, the fibres grown under a reducing atmosphere ($H_2/N_2$) provide higher thermoelectric properties.

Table 1 - Relevant thermoelectric properties at 300 - 900 °C reported for $Ti_{1-x}Ta_xO_2$ systems.

| Composition | Preparation | Conductivity (S/cm) | Seebeck coefficient ($\mu$V/K) | PF ($\mu$W/m/K$^2$) | Ref. |
|---|---|---|---|---|---|
| $Ti_{0.993}Ta_{0.007}O_2$ | Standard ceramic route in air | [0.3 to 5] | [-429 to -298] | [5 to 43] | [1] |
| $Ti_{0.95}Ta_{0.05}O_2$ | Laser growth in air | 20 | -395 | 317 | Prior art |
| $Ti_{0.95}Ta_{0.05}O_2$ | Laser growth in $H_2/N_2$ | 239 | -176 | 737 | Present invention |

Comparing the values obtained in the present invention to those of the prior art, it is also possible to observe a noticeable improvement in electrical conductivity reached by the methods according to the present invention.

## INDUSTRIAL APPLICATIONS

The $Ti_{1-x}M_xO_{2-y}$-based fibres, wherein x, y and M are as described hereinabove, obtained by the present invention can be applied mainly in the thermoelectrics field. One example of application is a thermoelectric module used for waste heat recovery in high-temperature industry, e.g., ceramics, concrete, steelmaking etc.

It is apparent to persons skilled in the art that the present invention is not limited to the detail of the above exemplary embodiments, and the present invention can be realized in other concrete forms without deviating from the spirit or essential features of the present invention. Therefore, in any way, the embodiments should be regarded as exemplary, but not restrictive. The scope of the present invention is defined by the attached claims rather than by the above specification, so it is intended to encompass all variations falling within the meaning and scope of equivalent elements of the claims in the present invention. Any references in the claims shall not be deemed to limit the claims involved.

In addition, it should be understood that although the present specification is described in terms of embodiments, not each embodiment comprises only one independent technical solution. The specification is stated in this way only for the sake of clarity. Technical personnel skilled in the art should take the specification as a whole, and the technical solutions in various embodiments can also be combined properly to form other embodiments that can be understood by those skilled in the art.

This work was supported by the project POCI-01-0145-FEDER-031875, financed by COMPETE 2020 Program and National Funds through the FCT/MEC and when applicable cofinanced by FEDER under the PT2020 Partnership Agreement.

## REFERENCE SIGNS LIST

1 - Gas-tight growth chamber

2 - External atmosphere generator arrangement

2A - Vacuum subsystem

2B - Pressurized gas source

20 - Controlled atmosphere for fibre growth
3 - Melting zone
4 - Optical apparatus
5A, 5B - Lower and upper spindles

## CITATIONS LIST

## NON-PATENT LITERATURE

[1] M. A. Alim et al., "Electrical conductivity and defect disorder of tantalum-doped Ti02," J. Am. Ceram. Soc., vol. 100, no. 9, pp. 4088-4100, 2017, doi: 10.1111/jace.14959.
[2] F. P. Carreira, N. M. Ferreira, and A. V. Kovalevsky, "Laser processing as a tool for designing donor-substituted calcium manganite-based thermoelectrics," J. Alloys Compd., vol. 829, p. 154466, 2020, doi: 10.1016/j.jallcom.2020.154466.

## Claims

1. A method of producing, by means of the Laser Floating Zone (LFZ) technique, an electroceramic fibre of the formula (I):

$$Ti_{1-x}M_xO_{2-y} \qquad (I)$$

wherein, in formula (I):

M is a transition metal chosen from group 5 of the Periodic Table;
x is in the range from 0.1 to 0.4, preferably from 0.1 to 0.2;
y is in the range from 0 to 0.2;

wherein said method comprises the steps:
b) feeding two precursor rods, one feed precursor rod and one seed precursor rod, wherein said rods are made of a mixture comprising materials of formulas (II) and (III):

$$TiO_z \qquad (II)$$

wherein, in formula (II):
z is in the range from 1.8 to 2.25;

$$M_kO_w \qquad (III)$$

wherein, in formula (III):

M is a transition metal chosen from group 5 of the Periodic Table;
k is in the range from 1.9 to 2.1;
w is in the range from 4.9 to 5.1;
b) placement and vertical end-to-end alignment of said feed precursor rod and said seed precursor rod within a gas-tight growth chamber wherein the vertical end-to-end alignment of the feed precursor rod and the seed precursor rod is such that their ends are facing each other;
c) start the rotation of the feed precursor rod and the seed precursor rod in opposite directions relatively to each other;
d) focus a laser beam on the feed precursor rod, at the end of said feed precursor rod, said end being the one facing the end of the seed precursor rod;
e) increase the laser power until said end of the feed precursor rod melts;
f) join the ends of the feed precursor rod and the seed precursor rod until a uniform molten zone is achieved;

g) set a feed speed and a growth speed, wherein the growth speed is the speed of the seed rod and is in the range of 0.1-1000 mm/h, preferably in the range of 0.1-100 mm/h, more preferably in the range of 10-100 mm/h; wherein the feed speed is adjusted such that a diameter of the melting zone is kept constant and is in the range of 0.1-1000 mm/h, preferably in the range of 0.1-100 mm/h, more preferably in the range of 10-100 mm/h;

h) start fibre growth by moving the rods vertically at the growth speed respectively to the laser beam focus;

**characterized in that** the method comprises the additional following step:

b') pump the air out of the growth chamber by means of a vacuum subsystem (2A) until a pressure lower than the atmospheric pressure is achieved, wherein the pressure achieved is preferably from 1 to $10^3$ Pa; wherein
step b') occurs after step b) and before step c).

2. A method of producing by means of the Laser Floating Zone (LFZ) technique an electroceramic fibre of the formula (I):

$$Ti_{1-x}M_xO_{2-y} \qquad (I)$$

wherein, in formula (I):

M is a transition metal chosen from group 5 of the Periodic Table;
x is in the range from 0.1 to 0.4, preferably from 0.1 to 0.2;
y is in the range from 0 to 0.2;

wherein said method comprises the steps:
b) feeding two precursor rods, one feed precursor rod and one seed precursor rod, wherein said rods are made of a mixture comprising materials of formulas (II) and (III):

$$TiO_z \qquad (II)$$

wherein, in formula (II):
z is in the range from 1.8 to 2.25;

$$M_kO_w \qquad (III)$$

wherein, in formula (III):

M is a transition metal chosen from group 5 of the Periodic Table;
k is in the range from 1.9 to 2.1;
w is in the range from 4.9 to 5.1;
b) placement and vertical end-to-end alignment of said feed precursor rod and said seed precursor rod within a gas-tight growth chamber wherein the vertical end-to-end alignment of the feed precursor rod and the seed precursor rod is such that their ends are facing each other;
c) start the rotation of the feed precursor rod and the seed precursor rod in opposite directions relatively to each other;
d) focus a laser beam on the feed precursor rod, at the end of said precursor rod, said end being the one facing the end of the seed precursor rod;
e) increase the laser power until said end of the feed precursor rod melts;
f) join the ends of the feed precursor rod and the seed precursor rod until a uniform molten zone is achieved;
g) set a feed speed and a growth speed, wherein the growth speed is the speed of the seed rod and is in the range of 0.1-1000 mm/h, preferably in the range of 0.1-100 mm/h, more preferably in the range of 10-100 mm/h; wherein the feed speed is adjusted such that a diameter of the melting zone is kept constant and is in the range of 0.1-1000 mm/h, preferably in the range of 0.1-100 mm/h, more preferably in the range of 10-100 mm/h;
h) start fibre growth by moving the rods vertically at the growth speed respectively to the laser beam focus;

**characterized in that** the method comprises the additional following step:

b") fill the growth chamber with a gas provided by means of a pressurization subsystem comprising a pressurized gas source (2B) until a relative pressure in the range from 0.1 to $1.5 \times 10^5$ Pa is achieved;

wherein
step b") occurs after step b) and before step c).

3. The method according to claim 2, wherein the method comprises the additional following step:
   b') pump the air out of the growth chamber by means of said vacuum subsystem (2A) until a pressure lower than the atmospheric pressure is achieved, wherein the pressure achieved is preferably from 1 to $10^3$ Pa;
   wherein

   step b') occurs after step b); and
   step b') occurs before step b").

4. The method according to any one of the preceding claims, wherein the vertical movement of the rods is an upward movement or the vertical movement of the rods is a downward movement, which movement is performed at said growth speed set in step g).

5. The method according to any one of the preceding claims, wherein said laser beam is emitted from a $CO_2$ laser source, which electromagnetic wave has a wavelength of around 10,600 nm.

6. The method according to any one of the preceding claims, wherein said feed and seed rods' material is able to absorb radiation of a wavelength of around 10,600 nm.

7. The method according to any one of the claims 2 to 6, wherein the pressurized gas from the source of pressurized gas source (2B) comprises a reducing gas, for example, hydrogen, or a reducing mixture of hydrogen and any other suitable gas.

8. An electroceramic fibre comprising an oxide of the formula (I):

   $$Ti_{1-x}M_xO_{2-y} \qquad (I)$$

   wherein, in formula (I):

   M is a transition metal chosen from group 5 of the Periodic Table;
   x is in the range from 0.1 to 0.4, preferably from 0.1 to 0.2;
   y is in the range from 0 to 0.2;
   **characterized in that** said electroceramic fibre is an oriented, texturized fibre rod with a crystalline structure.

9. The electroceramic fibre according to claim 8, **characterized in that** said electroceramic fibre is obtained by the method as defined in claim 1 or in any one of claims 4 to 7.

10. The electroceramic fibre according to claim 8, **characterized in that** said electroceramic fibre is obtained by the method as defined in any one of claims 2 to 7.

11. The electroceramic fibre according any one of claims 8 to 10, **characterized in that** said transition metal M is Ta and/or Nb, preferably Ta.

12. The electroceramic fibre according any one of claims 8 to 11, **characterized in that** it has a thermoelectric properties power factor from 100 to 1500 $\mu$W/m/K$^2$,

13. A system configured to implement the method as defined in any one of claims 1 to 7, comprising:

   - a gas-tight growth chamber (1);
   - at least one laser beam source;
   - at least one optical apparatus to focus the laser beam (4);
   - two spindles, one lower spindle (5A) and one upper spindle (5B), wherein the lower spindle (5A) is orthogonally connected to the internal bottom face of the gas-tight growth chamber (1) and the upper spindle (5B) is orthogonally connected to the internal top face of the gas-tight growth chamber (1), said top face opposite to the bottom face;

**characterized in that** the system further comprises
an external atmosphere generator arrangement (2), fluidly connected to the gas-tight growth chamber (1), wherein the external atmosphere generator arrangement (2) comprises:

a vacuum subsystem (2A) connected in fluid communication to said gas-tight growth chamber (1); and
at least one pressurization subsystem comprising a pressurized gas source (2B), which is connected in fluid communication to said gas-tight growth chamber (1);
wherein said vacuum subsystem (2A) and/or said pressurization subsystem comprising a pressurized gas source (2B) are configured to provide a desired atmosphere inside the growth chamber.

14. The system according to claim 13, wherein said vacuum subsystem (2A) is configured to generate a pressure lower than the atmospheric pressure inside the gas-tight growth chamber (1), for example, a pressure from 1 to $10^3$ Pa.

15. The system according to claim 13 or claim 14, wherein said pressurization subsystem comprises a gas source (2B) containing gas at a pressure higher than the atmospheric pressure, for example, at a relative pressure from 0.1 up to around $1.5 \times 10^5$ Pa.

Fig.1

Fig.2

Fig.3

Fig.4

Europäisches
Patentamt

European
Patent Office

Office européen
des brevets

# EUROPEAN SEARCH REPORT

Application Number

EP 22 18 6468

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PT 115 438 A (UNIV AVEIRO [PT]) 9 October 2020 (2020-10-09) * the whole document * | 13-15 | INV. C30B13/24 C30B29/22 |
| X | ES 2 109 193 A1 (CONSEJO SUPERIOR INVESTIGACION [ES]) 1 January 1998 (1998-01-01) * figure 1 * * column 4, line 66 – column 5, line 54 * | 13-15 | |
| A | KR 2003 0034580 A (HANYANG HAK WON CO LTD [KR]) 9 May 2003 (2003-05-09) * the whole document * | 1-12 | |
| A | US 2018/258554 A1 (GENG FENGXIA [CN] ET AL) 13 September 2018 (2018-09-13) * claims 1-4 * | 8-12 | |

TECHNICAL FIELDS
SEARCHED      (IPC)

C30B

The present search report has been drawn up for all claims

| Place of search | Date of completion of the search | Examiner |
|---|---|---|
| The Hague | 20 December 2022 | Schmitt, Christian |

EPO FORM 1503 03.82 (P04C01)

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................................

& : member of the same patent family, corresponding
    document

## ANNEX TO THE EUROPEAN SEARCH REPORT
## ON EUROPEAN PATENT APPLICATION NO.

EP 22 18 6468

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2022

| Patent document cited in search report | | Publication date | Patent family member(s) | | Publication date |
|---|---|---|---|---|---|
| PT 115438 | A | 09-10-2020 | NONE | | |
| ES 2109193 | A1 | 01-01-1998 | ES | 2109193 A1 | 01-01-1998 |
| | | | WO | 9740214 A1 | 30-10-1997 |
| KR 20030034580 | A | 09-05-2003 | NONE | | |
| US 2018258554 | A1 | 13-09-2018 | US | 2018258554 A1 | 13-09-2018 |
| | | | WO | 2017045181 A1 | 23-03-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. A. ALIM et al.** Electrical conductivity and defect disorder of tantalum-doped Ti02. *J. Am. Ceram. Soc.,* 2017, vol. 100 (9), 4088-4100

- **F. P. CARREIRA ; N. M. FERREIRA ; V. KOVA-LEVSKY.** Laser processing as a tool for designing donor-substituted calcium manganite-based thermo-electrics. *J. Alloys Compd.,* 2020, vol. 829, 154466